# EUROPÄISCHE PATENTANMELDUNG

(11) **EP 0 703 629 A2**
(43) Veröffentlichungstag der Anmeldung: **27.03.1996**
(21) Anmeldenummer: 95113532.6
(22) Anmeldetag: 29.08.1995
(51) Int. Cl.: H01L 29/808, H01L 21/337

(54) **Vertikaler Feldeffekt-Transistor hoher Leistung**

(30) Priorität: 30.08.1994 DE 4430732
(71) Anmelder: Daimler-Benz Aktiengesellschaft, D-70546 Stuttgart (DE)
(72) Erfinder: Loose, Werner, Dr., D-65779 Kelkheim (DE); Korec, Jacek, Dr., D-64546 Mörfelden-Walldorf (DE); Niemann, Ekkehard, Dipl.-Phys., D-63477 Maintal (DE); Schlangenotto, Heinrich, Dr., D-63263 Neu Isenburg (DE); Held, Raban, Dipl.-Phys., D-63776 Mombris (DE)
(74) Vertreter: Erbacher, Alfons, Dipl.-Ing.

(57) **Zusammenfassung**

Bei einem vertikalen Feldeffekt-Transistor hoher Leistung mit einem auf einem Substrat angebrachten Drainkontakt, einer Driftzone, einem Gate- und einem Sourcekontakt, wobei die Elektrodenanordnung des Feldeffekt-Transistors mit einem vergrabenen Gate überwiegend vertikal ausgeführt ist, ist vorgesehen, daß die Kanalzone (5) im wesentlichen lateral entlang der vergrabenen Gatezone (7) angeordnet ist und über einen Durchlaß (14) darin mit der Driftzone (4) verbunden ist.

## Beschreibung

Die Erfindung betrifft einen vertikalen Feldeffekt-Transistor nach dem Oberbegriff des Anspruchs 1 und ein Verfahren zu seiner Herstellung.

Ein solcher Feldeffekt-Transistor ist aus der Veröffentlichung von B. Jayant Baliga: "Modern Power Devices", John Wiley und Sons, N.Y. 1987, bekannt. Im Kapitel 4 des Buches über Leistungs-JFETs wird eine Struktur beschrieben, welche ein zwischen Drain und Source gelegenes vergrabenes Gate behandelt. Hierbei treten kurze Kanäle auf, welche auch in die gitterartigen Strukturen des Gates ein unzureichendes Abschnür- und Sperrverhalten zeigen.

Die Dotierung der Driftzone zwischen Gate und Drain bestimmt die maximale Sperrspannung. Hohe Sperrspannungen erfordern eine geringe Dotierung der Driftzone, was aber mit einem hohen Driftzonen-Widerstand einhergeht.

Die Nachteile der bisher üblichen Technik für vertikale JFETs für hohe Leistungen sind folgende:
- Die vertikale Kanalzone hat nur dann eine gute Abschnürung zur Folge, wenn das Verhältnis von Kanalbreite zur -länge sehr viel kleiner als "1" ist. Die Länge des Kanals bzw. seine Tiefe ist allerdings technologisch beschränkt. Die Grenzen der lateralen Strukturierung, die durch die Maskentechnik gegeben sind, verhindern dann die Einstellung des genannten günstigen Verhältnisses zwischen Kanalbreite auf -länge. Das hat ein schlechtes Abschnürverhalten, d. h. geringe Spannungsverstärkung zur Folge.
- Für hohe Sperrspannungen werden eine geringe Dotierung und eine entsprechend große Länge der Driftzone erforderlich. Durch den daraus resultierenden hohen Widerstand ("On-Widerstand") der Driftzone wird die maximale Stromdichte stark eingeschränkt. Für Silizium-Leistungsbauelemente finden derartige Strukturen folglich keine Verwendung.

Der Erfindung liegt die Aufgabe zugrunde, einen vertikalen Feldeffekt-Transistor hoher Spannungsfestigkeit der eingangs genannten Art so weiterzuentwickeln, daß die Abschnürung der Kanalzone schon bei kleinen Gatespannungen einsetzt und daß der Widerstand der Kanaizone sich bei dieser Maßnahme im üblichen Rahmen hält.

Diese Aufgabe wird durch die im Kennzeichen des Anspruchs 1 aufgeführten Merkmale gelöst.

Weiterbildungen der Erfindung und ein Verfahren zur Herstellung von erfindungsgemäßen vertikalen Feldeffekt-Transistoren sind in den Unteransprüchen enthalten.

Einsatzgebiete der Erfindung sind hochsperrende Bauelemente für die Antriebstechnik. Solche Bauelemente können beispielsweise für Umrichter in Elektroantrieben verwendet werden.

Das Wesen der Erfindung besteht darin, daß die Gateregion in dem vertikalen Bauelement zunächst lateral ausgebildet ist und eine große horizontale Ausbreitung aufweist. Diese laterale Kanalzone wird durch das vergrabene Gate besonders gut abgeschnürt. Darunter liegt die Driftzone, welche die Sperrspannung aufnimmt.

Für die Driftzone sind die Spannungsfestigkeit und der On-Widerstand des Materials von entscheidender Bedeutung. Günstig sind deshalb halbleitende Materialien mit einer großen Bandlücke (SiC, Diamant, AlN, GaN, BN), welche hohe Durchbruchspannungen bei im Vergleich zu Silizium erheblich höheren Dotierungen erreichen.
Das Substrat soll möglichst niederohmig sein. Als Material für das Substrat kann entweder das gleiche Material wie für die Driftzone genommen werden oder auch Silizium.

Die Vorteile der Anordnung liegen darin, daß Kanal- und Driftzone unabhängig voneinander optimiert werden können.
1. Beispielsweise kann die Dotierung im Kanal von der Driftzone verschieden gewählt werden, so daß in der Kanalzone ein geringerer Beitrag zum On-Widerstand entsteht.
2. Die Kanallänge kann beliebig variiert werden. Einerseits muß sie groß genug sein, um gute Abschnüreigenschaften zu gewährleisten, andererseits klein genug, um den On-Widerstand möglichst gering zu halten.
3. Heteroepitaxie bzw. Heteropolytypepitaxie ist möglich. Das Material bzw. der Polytyp für die Kanalzone besitzt dabei die höhere Mobilität und damit den geringeren On-Widerstand.
4. Große Spannungsverstärkungsfaktoren sind möglich und insbesondere ein Schaltzustand, bei dem der Transistor normalerweise ausgeschaltet ist (Normally-Off). Das liegt daran, daß die Kanalbreite durch die Höhe der Epitaxieschicht beliebig variiert werden kann.

Die Erfindung wird nachstehend anhand der Zeichnung näher erläutert.

Dabei zeigt:
- Fig. 1: einen Querschnitt durch das streifenförmige Bauelement;
- Fig. 2: die wesentlichen Abmessungen eines Bauelements;
- Fig. 3 - 7: die wesentlichen Schritte zur Herstellung eines erfindungsgemäßen Transistors;
- Fig. 8: die Ergebnisse einer Simulation des Betriebs eines Bauelements nach Fig. 2 und
- Fig. 9: eine alternative Ausführungsform des Bauelements nach Fig.1.

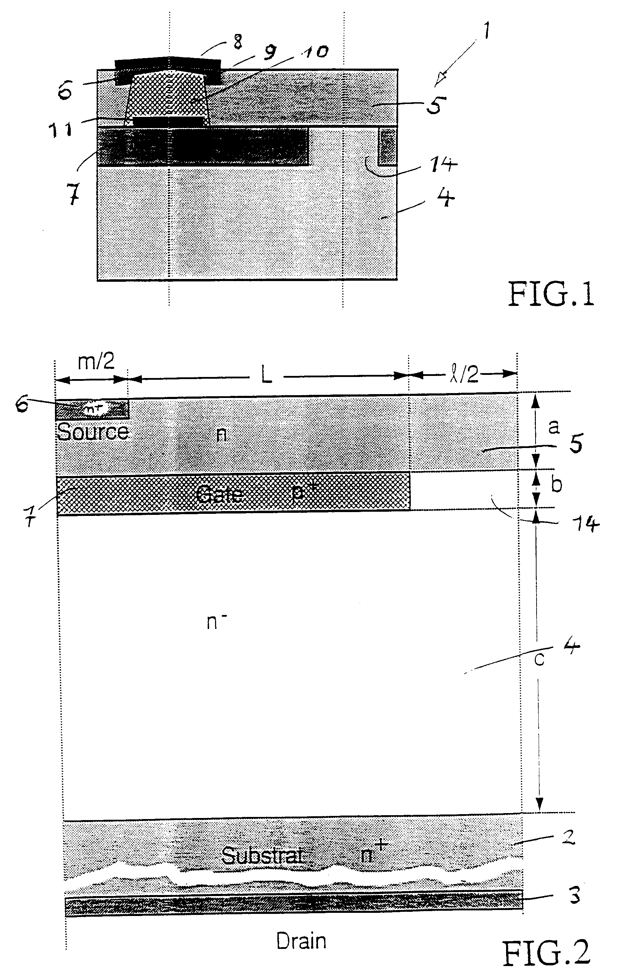

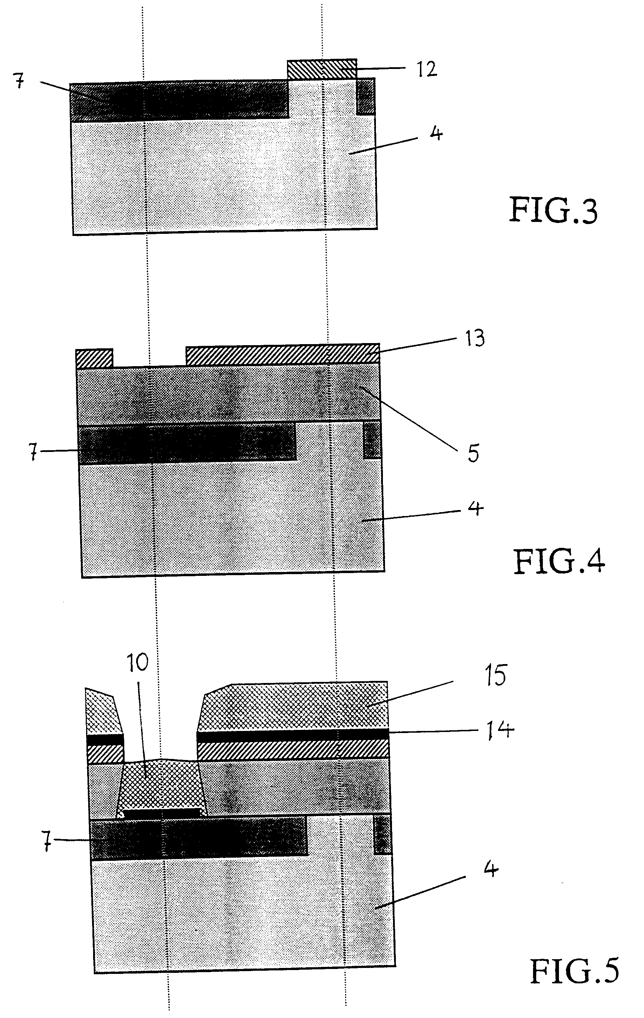

Der erfindungsgemäße vertikale Feldeffekt-Transistor 1 ist in Fig. 1 und 2 dargestellt und besteht im wesentlichen aus dem Substrat 2 (n⁺- oder p⁺- dotiert), an dessen Unterseite der Drainkontakt 3 angebracht ist, der Driftzone 4, welche eine n⁻-Dotierung aufweist, dem Gate 7, welches sich nur teilweise über die Driftzone 4 erstreckt und welches p⁺-dotiert ist, der n-dotierten Kanalzone 5 und der in diese Kanalzone eingebetteten Source-Region 6, welche n⁺-dotiert ist.

Als Material für das Substrat kann entweder das gleiche Material wie die Driftzone genommen werden oder auch Silizium. Das Substrat soll natürlich möglichst niederohmig sein. Das Driftzonenmaterial kann halbleitender Diamant, AlN, GaN, ein anderes Nitrid oder SiC sein. Dabei ist die Spannungsfestigkeit des Materials die entscheidende Größe. Die Kanalzone 5 besteht vorzugsweise aus dem gleichen Material wie die Driftzone 4, jedoch ist das Material so auszuwählen, daß die Majoritätsladungsträger dort eine möglichst hohe Mobilität besitzen.

Bei einem vorteilhaften Ausführungsbeispiel der Erfindung für hohe Sperrspannungen wird als Material für die Driftzone ein hexagonaler Polytyp von SiC (4H oder 6H) verwendet. Die n-dotierte Driftzone hat eine Konzentration der Dotierung von N_{D1} = 3 · 10¹⁵ cm⁻³. Die Tiefe c der Driftzone beträgt c = 38 µm. Die Maße sind in Fig. 2 eingetragen. Die Driftzone 4 erstreckt sich über die gesamte Breite der Siliziumkarbidscheibe.

Das Gate 7 ist in Fig. 2 ebenso wie das gesamte Bauelement nur zur Hälfte dargestellt. Seine Stärke beträgt b = 0,5 µm. Die Source 6 hat eine Breite von m = 2 µm, das Gate entsprechend eine Breite von m + 2 · L = 6 µm. Für jedes Bauelement bleibt neben dem Gate ein Durchlaß 14 übrig, welcher sich für die ganze Anordnung streifenförmig parallel zu den Elektroden erstreckt. Die Breite beträgt l/2 = 1 µm pro Bauelement. Die Tiefe der Kanalzone 5 beträgt a = 0,75 µm. Die Kanalzone besteht vorzugsweise aus 3C-SiC, welches heteroepitaktisch aufgewachsen ist. Die Dotierung der Kanalzone 5 beträgt N_{D2} = 10¹⁶ cm⁻³.

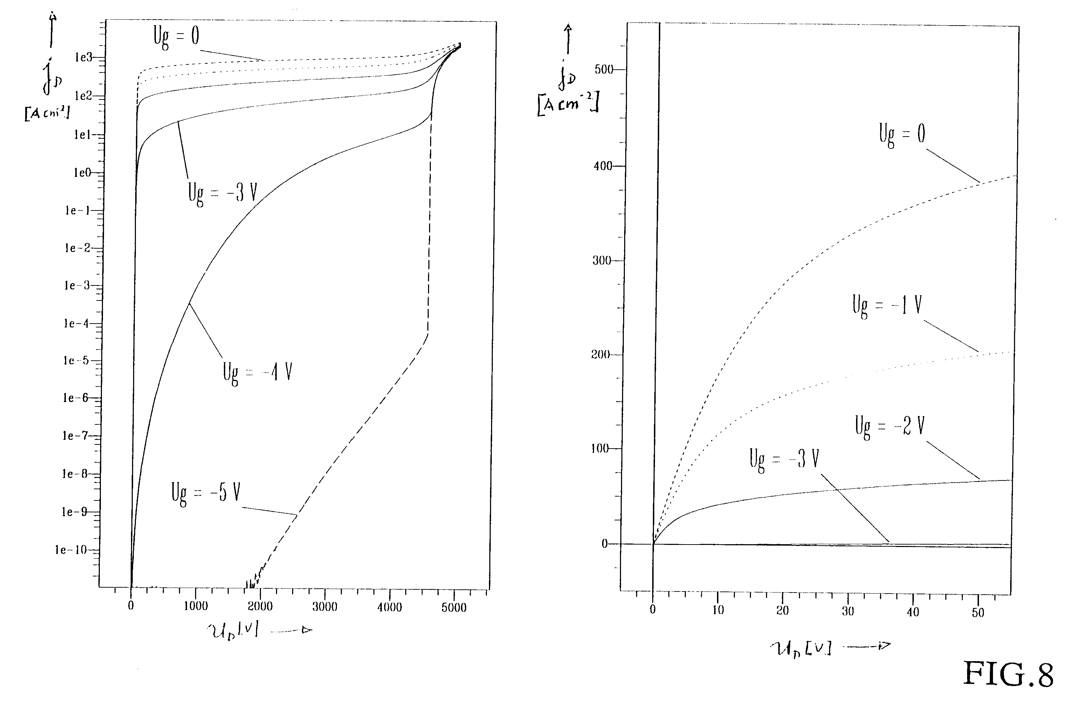

Fig. 8 zeigt Computer-Simulationsergebnisse für das in Fig. 2 dargestellte Bauelement. Aufgetragen ist in beiden Teilbildern die DrainStromdichte in Abhängigkeit von der Drain-Source-Spannun U_{D} für verschiedene Gate-Spannungen U_{g}. Aus dem linken Teilbild (halblogarithmische Darstellung) liest man eine Durchbruchspannung von ca. 4500 V ab. Das rechte Teilbild zeigt einen Ausschnitt der Kennlinie für kleine Drain-Source-Spannungen, aus dem der On-Widerstand Rₒₙ = 5 · 10⁻ Ωcm⁻ abgelesen werden kann. Auch das Sättigungsverhalten des Drainstroms wird deutlich.

Aus Fig. 8 entnimmt man, daß die Spannungsverstärkung dabei ca. 1000 ist. Legt man eine maximal zulässige Leistungsdichte von ca. 100 W/cm zugrunde, so ergeben sich maximale Stromdichten von ca. 50 A/cm.

Es ist allgemein bekannt, daß andere Durchbruchspannungen durch entsprechende Anpassung der Driftzonen-Dotierung N_{D1} eingestellt werden können. Alternativ zu der üblichen streifenförmigen Auslegung des Bauelements bieten sich zellenförmige Anordnungen von rotationssymetrischen Bauelementen an.

Bei Ausführungen für sehr hohe Sperrspannungen kann es vorteilhaft sein, wenn das Substrat p⁺-dotiert wird und damit als drainseitiger Emitter durch eine Ladungsträgerüberschwemmung der Driftzone den On-Widerstand weiter herabsetzt.

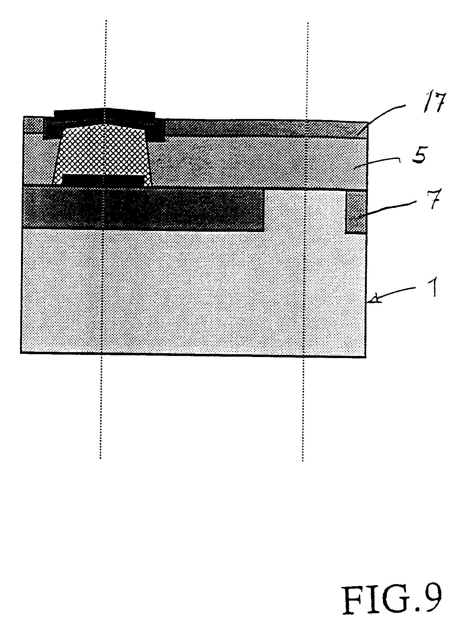

Die Gatezone 7 kann zur besseren Einschnürung des Kanalbereichs durch eine weitere Gatezone 17 an der Oberfläche des Bauelementes ergänzt werden (Fig. 9). Auf die Weise wird der Kanal von beiden Seiten eingeschnürt. Dazu kann ein pn-übergang angewendet werden. Eine weitere bevorzugte Strukturvariante wäre stattdessen eine Metall-Isolator-Halbleiterstruktur (MIS- bzw. MOS-Struktur). Der Gatekontakt an der Oberfläche wird mit dem vergrabenen Gate entlang der Leiterbahn punktuell verbunden oder aber an den Rändern, an welchen das vergrabene Gate an die Oberfläche geführt wird.

In einer alternativen Ausführungsform werden das vergrabene Gate 7 und der Sourcekontakt 8 kurzgeschlossen, so daß die Abschnürung des Kanals im wesentlichen durch die Oberflächen-Gatezone 17 erreicht wird.

Als Material für das Bauelement kommen alle Halbleiter mit großem Bandabstand in Frage. Solche Materialien sind z. B. Siliziumkarbid, AlN, GaN, BN und halbleitender Diamant. Diese Materialien werden eingesetzt, wenn es auf hohe Spannungsfestigkeit ankommt. Sie werden im allgemeinen auf einem Substrat aus gleichem Material wie die Driftzone oder Silizium abgeschieden oder gebondet. Das Bonden ist ein Verfahren, bei welchem zwei Halbleiterscheiben aufeinandergelegt und mittels hoher Temperatur miteinander verbunden werden.

Im folgenden wird das Herstellungsverfahren für das vorerwähnte bevorzugte Bauelement beschrieben. Zunächst wird SiC, das Ausgangsmaterial für das Bauelement als n⁻-Schicht 4, epitaxial auf einem niederohmigen, halbleitendem Substrat 2 abgeschieden. Die Dotierung N_{D1} wird entsprechend der maximalen Sperrspannung gewählt, ebenso die Dicke. Darauf wird, wie in Fig. 3 dargestellt, eine Maske 12 aus SiO₂ aufgebracht und eine p⁺-Zone 7 durch Ionenimplantation erzeugt. In einem weiteren Schritt wird die Maske 12 entfernt, und, wie Fig. 4 zeigt, eine Kanalzone 5 epitaxial abgeschieden. Dicke und Dotierung sind für die Kanalleitfähigkeit und günstige Abschnür- bzw. Sperreigenschaften zu optimieren. Bei SiC kann dies auch durch Polytypwechsel erreicht werden. Danach wird die zweite Maske 13 aufgebracht.

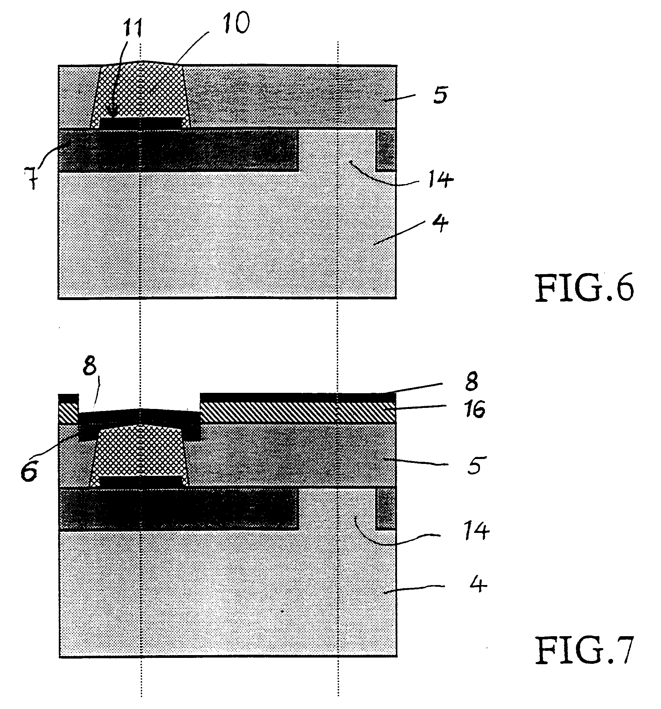

Als weiterer Schritt wird entsprechend Fig. 5 die Gate-Kontaktierung durchgeführt. Sie besteht darin, daß zunächst ein Graben geätzt und Metall 11 aufgesputtert wird. Als Metalle kommen beispielsweise Titan, Ni oder NiCr in Frage. Der Graben wird mit einem Isolator 10 aufgefüllt. Danach wird die zweite Maske entfernt. Dieser Prozeß wird als "lift-off" bezeichnet (Fig. 6).

Der nächste Schritt besteht im Aufbringen der dritten Maske 16 (s. Fig. 7) für die n⁺-Ionenimplantation zur Vorbereitung des Sourcekontakts. Es entsteht die n⁺-Schicht 6. Dann wird Metall 8 aufgesputtert. Der letzte Schritt besteht im Beseitigen der dritten Maske; die Oberfläche wird gegebenenfalls passiviert. Das Ergebnis ist das fertige Bauelement nach Fig. 1 und 2.

Die Rückseite des Substrats wird in üblicher Weise kontaktiert und bildet den Drainkontakt 3, der in Fig. 2 schematisch dargestellt ist.

## Patentansprüche

1. Vertikaler Feldeffekt-Transistor hoher Leistung mit einem auf einem Substrat angebrachten Drainkontakt, einer Driftzone, einem Gate- und einem Sourcekontakt, wobei die Elektrodenanordnung des Feldeffekt-Transistors mit einem vergrabenen Gate überwiegend vertikal ausgeführt ist,
**dadurch gekennzeichnet,**
daß die Kanalzone (5) im wesentlichen lateral entlang der vergrabenen Gatezone (7) angeordnet ist und über einen Durchlaß (14) darin mit der Driftzone (4) verbunden ist.

2. Vertikaler Feldeffekt-Transistor nach Anspruch 1, dadurch gekennzeichnet, daß die Polarität der Dotierung der vergrabenen Gatezone (7) entgegengesetzt, die Dotierung des Substrats (2) gleich oder entgegengesetzt derjenigen der Driftzone (4) und der Kanalzone (5) ist.

3. Vertikaler Feldeffekt-Transistor nach Anspruch 1 oder 2, dadurch gekennzeichnet, daß die Driftzone (4) aus dem Halbleitermaterial mit großem Bandabstand besteht.

4. Vertikaler Feldeffekt-Transistor nach einem der Ansprüche 1 bis 3, dadurch gekennzeichnet, daß das Substrat (3) aus dem gleichem Material wie die Driftzone (4), bzw. einem Polytyp desselben, besteht, welches möglichst niederohmig dotiert ist.

5. Vertikaler Feldeffekt-Transistor nach einem der Ansprüche 1 bis 3, dadurch gekennzeichnet, daß das Substrat (3) aus Silizium besteht, welches möglichst niederohmig dotiert ist.

6. Vertikaler Feldeffekt-Transistor nach einem der Ansprüche 1 bis 5, dadurch gekennzeichnet, daß die Kanalzone (5) aus dem gleichen Material wie die Driftzone (4) besteht.

7. Vertikaler Feldeffekt-Transistor nach einem der Ansprüche 1 bis 5, dadurch gekennzeichnet, daß die Kanalzone (5) aus einem anderen Halbleitermaterial besteht, welches epitaktisch aufgewachsen ist.

8. Vertikaler Feldeffekt-Transistor nach einem der Ansprüche 1 bis 5, dadurch gekennzeichnet, daß die Kanalzone (5) aus 3C-SiC besteht, welches epitaktisch aufgewachsen ist.

9. Vertikaler Feldeffekt-Transistor nach einem der Ansprüche 1 bis 8, dadurch gekennzeichnet, daß an der Oberfläche des Feldeffekt-Transistors eine zusätzliche Gate-Zone zur Einschnürung des Kanalbereichs durch Feldeffekt einer Metall-Isolator-Halbleiterstruktur oder eines pn-Übergangs angeordnet ist.

10. Vertikaler Feldeffekt-Transistor nach einem der Ansprüche 1 bis 9, dadurch gekennzeichnet, daß der vergrabene Gate-Kontakt (11) in einem Randbereich freigelegt und kontaktiert ist.

11. Vertikaler Feldeffekt-Transistor nach einem der Ansprüche 1 bis 10, dadurch gekennzeichnet, daß die Oberflächen-Gatezone (17) mit dem Gate (7) leitend verbunden ist.

12. Vertikaler Feldeffekt-Transistors nach einem der Ansprüche 1 bis 10, dadurch gekennzeichnet, daß die vergrabene Gatezone (7) mit dem Source-Kontakt (8) elektrisch kurzgeschlossen ist und zur Einschnürung der Kanalzone die Oberflächen-Gatezone (17) getrennt kontaktiert ist.

13. Vertikaler Feldeffekt-Transistors nach einem der Ansprüche 1 bis 12, dadurch gekennzeichnet, daß für SiC die Kanalzone mit N_{D2} = 10¹⁵ bis 10¹⁷ cm⁻³ dotiert ist.

14. Vertikaler Feldeffekt-Transistors nach einem der Ansprüche 1 bis 13, dadurch gekennzeichnet, daß für SiC die Driftzone mit N_{D1} = 10¹⁵ bis 10¹⁷ cm⁻³ dotiert ist.

15. Verfahren zum Herstellen eines vertikalen Feldeffekt-Transistors nach einem der Ansprüche 1 bis 14, dadurch gekennzeichnet, daß auf einem niederohmigen Substrat (2) eine Driftzone (4) abgeschieden wird, daß eine mit einem Durchlaß (14) versehene Gatezone (7) mit einer Dotierung, deren Polarität der Dotierung der Driftzone entgegengesetzt ist, erzeugt wird, daß darauf eine Kanalzone (5) abgeschieden und ein Sourcegebiet in die Kanalzone implantiert wird und daß anschließend die Kontaktierung der Gate-, Source- und Draingebiete durchgeführt werden.

16. Verfahren nach Anspruch 15, dadurch gekennzeichnet, daß die Gatezone (7) durch Ionenimplantation in die Driftzone erzeugt wird, wobei der Durchlaß (14) durch eine Maskierung hergestellt wird.

17. Verfahren nach Anspruch 15, dadurch gekennzeichnet, daß die Gatezone (7) epitaktisch auf die Driftzone (4) aufgewachsen wird, wobei der Durchlaß (14) durch Ionenimplantation erzeugt wird.

18. Verfahren zum Herstellen eines vertikalen Feldeffekt-Transistors nach einem der Ansprüche 1 bis 14, dadurch gekennzeichnet, daß auf einem niederohmigen Substrat (2) eine Epitaxieschicht abgeschieden wird, daß durch eine tiefe Ionenimplantation eine Gatezone (7) mit einer Dotierung, deren Polarität der Dotierung der Epitaxieschicht entgegengesetzt ist, hergestellt wird, daß dabei die Epitaxieschicht in eine Driftzone (4) und eine Kanalzone (5) geteilt wird, welche mit einem durch Maskierung entstehenden Durchlaß (14) verbunden sind, und daß an die Implantation des Sourcegebietes anschließend die Kontaktierungen der Gate-, Source- und Draingebiete durchgeführt werden.

19. Verfahren nach einem der Ansprüche 15 bis 18, dadurch gekennzeichnet, daß eine weitere Gatezone (17) an der Oberfläche des Bauelements durch eine Abscheidung und Strukturierung von entsprechenden Schichten als eine Metall-Isolator-Halbleiterstruktur hergestellt wird.

20. Verfahren nach Anspruch 19, dadurch gekennzeichnet, daß die Gatezone (17) durch Ionenimplantation als ein pn-Übergang hergestellt wird.

21. Verfahren nacheinem der Ansprüche 15 bis 20, dadurch gekennzeichnet, daß der Gatekontakt (11) in einem geätzten Graben hergestellt wird, welcher mit einem Isolator (10) gefüllt wird.

22. Verfahren nach einem der Ansprüche 15 bis 20, dadurch gekennzeichnet, daß die Gatezone (7) mittels einer die Kanalzone durchdringenden Ionenimplantation an die Oberfläche geführt und dort kontaktiert wird.
